# EUROPEAN PATENT APPLICATION

(11) **EP 4 016 187 A1**
(43) Date of publication of application: **22.06.2022**
(21) Application number: 20214417.6
(22) Date of filing: 16.12.2020
(51) Int. Cl.: G03F 7/20

(54) **LITHOGRAPHY APPARATUS COMPONENT AND METHOD**

(71) Applicant: ASML Netherlands B.V., 5500 AH Veldhoven (NL)
(72) Inventor: BLAUW, Michiel Alexander, 5500 AH Veldhoven (NL); DER KINDEREN, Ronny, 5500 AH Veldhoven (NL)
(74) Representative: ASML Netherlands B.V.

(57) **Abstract**

There is provided a reticle stage for a lithography apparatus, said reticle stage comprising: at least one optical element having an area to be cleaned; a radiation beam target; and a control system configured to direct a radiation beam to the radiation beam target wherein the interaction of the radiation beam and a gas creates an optical element-cleaning plasma, wherein the radiation beam target is located to provide the optical element-cleaning plasma to the at least one optical element to clean the optical element, and wherein the at least one optical element is a different element than the radiation beam target, preferably wherein the heat sensitive element is a fiducial. Also described are a fiducial for a lithographic apparatus comprising at least one curved edge, a lithographic apparatus comprising the reticle stage or fiducial, and a method of cleaning an optical element of a reticle stage.

## Description

### FIELD

The present invention relates to a reticle stage for a lithographic apparatus, a fiducial for a lithographic apparatus, a lithographic apparatus comprising such a reticle stage and/or a fiducial, a method of cleaning at least one optical element of a reticle stage of a lithography apparatus, and the use of a reticle stage, fiducial, or such method in a lithographic apparatus or method, as well as a computer program and a computer readable medium configured to execute the steps of the methods described herein.

### BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

In operation, contamination, such as carbon, may be deposited on surfaces within a lithographic apparatus. Certain of these surfaces are located on optical elements of the apparatus, which are elements which interact with a radiation beam in operation. The performance of such optical elements is reduced due to the build-up of contamination, such as carbon, on the surface thereof. It is therefore desirable to clean any contaminated surfaces within the lithographic apparatus, particularly any surfaces which interact with the radiation beam.

The present invention has been devised to provide an improved or alternative system for cleaning one or more optical elements, which are heat-sensitive elements, of a lithographic apparatus.

### SUMMARY OF THE INVENTION

According to a first aspect of the present invention, there is provided a reticle stage for a lithography apparatus, said reticle stage comprising at least one optical element having an area to be cleaned, a radiation beam target, and a control system configured to direct a radiation beam to the radiation beam target wherein the interaction of the radiation beam and a gas creates an optical element-cleaning plasma, wherein the radiation beam target is located to provide the optical element-cleaning plasma to the at least one optical element to clean the optical element, and wherein the at least one optical element is a different element than the radiation beam target. The reticle stage is configured to receive an object. In one embodiment, the object is a reticle.

Previously, fiducial carbon cleaning in a lithographic apparatus with EUV-induced plasma leads to very high temperatures on the fiducial, which is an optical element, and this quickly leads to damage to the fiducial resulting in degradation of the reflectivity of the fiducial. This results in the need to replace the fiducial, which takes a long time and causes extended down time of the apparatus, which is clearly undesirable. Fiducials may be also considered as optical elements. Optical elements may be used for reflecting a radiation beam and/or for interacting with a radiation beam in operation and/or for obtaining information from said radiation beam reflected. Fiducials are used in the reticle stage of a lithographic apparatus and if they are cleaned with direct EUV radiation, the fiducials are prone to degradation and it may no longer be possible for them to function adequately. As such, the whole reticle stage needs to be changed, which results in a long downtime of the apparatus. The present invention seeks to address this problem. Fiducials and other heat sensitive elements are also used elsewhere in a lithographic apparatus and may similarly require replacement or repair if they are damaged.

It has been found that it is possible to indirectly clean a heat sensitive element of a lithographic apparatus, such as an optical element, by directing the radiation beam, such as the EUV radiation beam, onto a radiation beam target, which is a different element than the optical element itself. The radiation beam interacts with a gas, typically hydrogen, within the lithographic apparatus to generate a plasma. The plasma is generated in a position where it is able to reach the optical element to be cleaned and remove contamination therefrom. It has not previously been realized that an optical element of a lithography apparatus could be cleaned in this way. Typically, the contamination comprises carbon, but in other cases may be other materials, such as tin, and the plasma is able to remove the contamination from the heat sensitive element. An advantage of the present invention is that creating a plasma by hitting a radiation beam target other than the heat sensitive optical element being cleaned is that it is possible to do so without the radiation beam hitting the heat sensitive optical element itself, thereby reducing the high thermal load on the heat sensitive optical element. There is a significant improvement in the thermal impact upon the heat sensitive optical element since no direct radiation energy, such as that from an EUV radiation beam, is absorbed by the heat sensitive optical element. A further advantage of the present invention is that the radiation beam does not directly illuminate the heat sensitive optical element and so any hydrocarbons produced by the interaction between the carbon contamination and hydrogen plasma are not immediately broken down back into carbon again. In systems where direct illumination is carried out, the cleaning process may be partially reversed by this mechanism. The present invention allows for the cleaning of any heat sensitive optical elements that are subject to contamination. The heat sensitive element is preferably a fiducial mark. The heat sensitive element may be physically connected to, attached to, and/or included in the reticle stage. Therefore, the present invention advantageously increases the lifetime of said reticle stage. Although non-optical elements may previously have been cleaned by the generation of a cleaning plasma, such elements are not as sensitive as optical elements and so there was no appreciation that a plasma produced as described herein would be able to clean optical elements and do so without damage.

The radiation beam target may be an illumination shutter for limiting an area of a heat sensitive element to be illuminated, a reticle clamp, a beam dump, or an absorber element configured to absorb energy from the radiation beam and create a plasma. The illumination shutter may also be referred to as a reticle masking shutter, or a ReMa blade or unit, or simply ReMa. As such, the illumination shutter may be for limiting an area of a substrate to be illuminated and/or limiting an area of an optical element to be illuminated. The key feature of the beam target is that it is able to withstand direct exposure to the radiation beam, for example an EUV radiation beam, and generate a plasma from the surrounding gas. Since the beam target is not the heat sensitive element being cleaned, it is possible to manufacture the radiation beam target from materials that are more able to withstand direct exposure to the radiation beam which is not necessarily the case for heat sensitive elements.

The control system may be configured to move the radiation beam target relative to the optical element having an area to be cleaned. Alternatively or additionally, the control system may be configured to move the optical element having an area to be cleaned to a position where it is able to interact with the optical element-cleaning plasma. In order to provide optimal cleaning performance, it is desirable for the plasma to be generated close to the area to be cleaned as the plasma will recombine over time so if the optical element is too far away from where the plasma is being generated, no cleaning will occur. As such, multiple modes are contemplated. There may be a static mode in which the at least one optical element and the radiation beam target are static and the radiation beam is directed onto the radiation beam target in order to create the plasma to clean the at least one optical element. Another mode may be to scan the radiation beam over the radiation beam target, and optionally partially expose a portion of the optical element having an area to be cleaned other than any absorber areas of the optical element. For example, the heat sensitive optical element may be a fiducial mark which is used in the lithographic apparatus to measure at least one parameter, such as position or alignment. The scanning mode may provide more uniform cleaning of the heat sensitive element which is being cleaned.

The apparatus may comprise a gas supply source configured to supply the gas. The gas may be hydrogen. The gas supply source may be configured to maintain a gas pressure in the range of around 1 to around 20 Pa. In order to generate a plasma, a gas within the lithographic apparatus must be present. Typically, inside of a lithographic apparatus is a low pressure hydrogen environment. The gas supply source is configured to supply such gas. In order to increase the rate at which the optical element is cleaned, the pressure of the gas, preferably hydrogen, may be increased, throughout the system or locally.

The radiation beam target may be connected to the at least one optical element. The radiation beam target may be located within around 25 mm of the at least one optical element. Since it is the plasma generated by the interaction of the radiation beam, radiation beam target and surrounding gas, it is desirable to have the radiation beam target close to the at least one optical element in order to generate plasma close to the area of the optical element to be cleaned.

The radiation beam target may comprise a conditioning system. Since the radiation beam target is directly illuminated by the radiation beam, it will heat up and so a conditioning system may be provided in order to manage this thermal load.

The radiation beam target may be a beam dump, which optionally comprises Chromium. The beam dump, as with any radiation beam target described herein, may include a conditioning system. The beam dump may be located on the reticle stage.

The radiation beam target may be located beside the optical element. In this way, the distance between the area of plasma generation and the area to be cleaned is minimized leading to lower plasma losses and higher cleaning rates.

The at least one optical element may comprise a fiducial mark having a mark area. The shape of the mark area may comprise a rectangle wherein at least one of the sides comprises a further semispherical area or a semielliptical area. Alternatively or additionally, the mark area comprises at least one curved edge. Existing fiducials have a rectangular shape and so a large proportion of the radiation beam illuminates absorber parts of the fiducial leading to very high temperatures on the fiducial, such as over 300°C, which leads to fast reflectivity degradation and the consequent need to repair or replace the fiducial, which results in considerable downtime for the lithographic apparatus. It has been found that a curved fiducial is able to reflect more incident radiation and so heat absorption of the fiducial is reduced. In particular, a curved fiducial may decrease the temperature from 350° to around 145°C, and this increases the time which the fiducial may be statically exposed to the radiation beam from less than 10 seconds to around 100 seconds. The reflective area of the fiducial may be increased, and it may be extended to the edge of the fiducial to further minimize the area which absorbs radiation. This provides for reduced thermal load and reduced temperature gain of the fiducial, whilst also allowing existing reticle stage scan-movement during production to be unchanged.

At least one illumination shutter comprises two blades and the control system is configured to window the at least one optical element with the two blades. The two blades may be referred to as reticle masking blades, also known as ReMa blades.

The blades may be positioned parallel to one another. The at least one optical element may be located between the blades. The at least one optical element may be located in a different plane to the plane of the blades. In embodiments, the optical element and the radiation beam target lie in the same plane or in parallel planes.

The reticle stage may comprise a conditioning circuit and a spacer. The spacer may be connected to the at least one optical element. The conditioning circuit may be configured to condition the at least one optical element and the spacer. The conditioning circuit may be named as thermal conditioning circuit.

The gas may be hydrogen. Hydrogen is typically used within lithographic apparatuses and hydrogen plasma is able to remove carbon deposits within the apparatus.

The radiation beam may be an EUV beam.

The reticle stage may be a system or a sub-system of a lithography machine. In lithography apparatuses, the reticle stage supports the reticle used in the lithographic apparatus to provide a pattern to an incident radiation beam.

The at least one optical element may be a fiducial mark. Fiducials or fiducial markers may be provided to assist with the alignment measurements in order to determine the correct alignment of an element of the apparatus. Fiducials may pattern a portion of the radiation beam for the purposes of measurement. For example, the fiducial may comprise a reflective diffraction grating, which when illuminated may form a plurality of diffraction orders. In any cases, the fiducial interacts with radiation in order to provide useful information. If the fiducial becomes contaminated, with for example carbon, it will be less effective at reflecting radiation and this is undesirable.

According to a second aspect of the present invention, there is provided a fiducial for a lithographic apparatus, wherein said fiducial comprises at least one curved edge. As described above, the curved edge has surprisingly been found to result in an increased reflectivity which thereby lowers the temperature to which the fiducial is raised upon exposure to a radiation beam. Existing fiducials are rectangular in shape and do not comprise at least one curved edge.

The fiducial may comprise two opposing linear edges. Whilst it has been found that it is advantageous for the fiducial to include at least one curved edge, not all of the edges need to be curved to display the advantageous effects. As such, the fiducial may comprise two opposing linear edges. The opposing linear edges may be parallel or may diverge. The fiducial may comprise one curved edge opposite one substantially linear edge. As such, in embodiments, the fiducial comprises three linear edges and one curved edge. The fiducial according to the second aspect may be the optical element according to the first aspect of the present invention.

According to a third aspect of the present invention, there is provided a lithographic apparatus comprising the reticle stage or fiducial according to the first or second aspects of the present invention.

According to a fourth aspect of the present invention, there is provided a method for cleaning at least one optical element of a reticle stage of a lithographic apparatus, said method comprising providing the reticle stage of any aspect of the present invention, and directing a radiation beam to the radiation beam target for creating an optical element-cleaning plasma.

According to a fifth aspect of the present invention, there is provided the use of a reticle stage, a fiducial, or a method according to any aspect of the present invention in a lithographic apparatus or method.

According to a sixth aspect of the present invention, there is provided a computer program product comprising instructions to cause the apparatus of any aspect of the present invention to execute the steps according to the method of the fourth aspect of the present invention. Also provided is a computer-readable medium having stored thereon a computer program according to the sixth aspect of the present invention.

It will be appreciated that features described in respect of one aspect or embodiment may be combined with any features described in respect of another aspect or embodiment and all such combinations are expressly considered and disclosed herein.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a lithographic apparatus which may include the reticle stage according to an embodiment of the invention;
Figure 2 depicts a schematic view of one embodiment of a reticle stage according to the present invention;
Figure 3 depicts a schematic view of an embodiment of a reticle stage according to the present invention;
Figure 4 depicts a schematic view of an embodiment of a reticle stage according to the present invention comprising a beam dump;
Figure 5 depicts a cleaning process in which the heat sensitive element and a radiation beam target move relative to one another; and
Figure 6a depicts the shape of a prior art fiducial and Figures 6b and 6c depict the shapes of fiducials according to an aspect of the present invention having at least one curved edge.

The features and advantages of the present invention will become more apparent from the detailed description set forth below when taken in conjunction with the drawings, in which like reference characters identify corresponding elements throughout. In the drawings, like reference numbers generally indicate identical, functionally similar, and/or structurally similar elements. The following detailed description will describe the invention in relation to optical elements having areas to be cleaned, but it will be appreciated that it is applicable to the cleaning of other heat sensitive elements.

### DETAILED DESCRIPTION

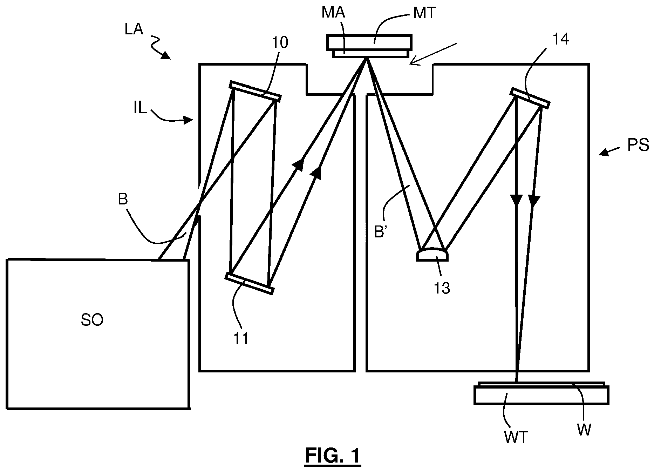

Figure 1 shows a lithographic apparatus. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. The illumination system IL is configured to condition the radiation beam B before it is incident upon the patterning device MA. The projection system is configured to project the radiation beam B (now patterned by the mask MA) onto the substrate W. The substrate W may include previously formed patterns. Where this is the case, the lithographic apparatus aligns the patterned radiation beam B with a pattern previously formed on the substrate W.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type which may be referred to as a laser produced plasma (LPP) source. A laser, which may for example be a CO₂ laser, is arranged to deposit energy via a laser beam into a fuel, such as tin (Sn) which is provided from a fuel emitter. Although tin is referred to in the following description, any suitable fuel may be used. The fuel may for example be in liquid form, and may for example be a metal or alloy. The fuel emitter may comprise a nozzle configured to direct tin, e.g. in the form of droplets, along a trajectory towards a plasma formation region. The laser beam is incident upon the tin at the plasma formation region. The deposition of laser energy into the tin creates a plasma at the plasma formation region. Radiation, including EUV radiation, is emitted from the plasma during de-excitation and recombination of ions of the plasma.

The EUV radiation is collected and focused by a near normal incidence radiation collector (sometimes referred to more generally as a normal incidence radiation collector). The collector may have a multilayer structure which is arranged to reflect EUV radiation (e.g. EUV radiation having a desired wavelength such as 13.5 nm). The collector may have an elliptical configuration, having two ellipse focal points. A first focal point may be at the plasma formation region, and a second focal point may be at an intermediate focus, as discussed below.

The laser may be separated from the radiation source SO. Where this is the case, the laser beam may be passed from the laser to the radiation source SO with the aid of a beam delivery system (not shown) comprising, for example, suitable directing mirrors and/or a beam expander, and/or other optics. The laser and the radiation source SO may together be considered to be a radiation system.

Radiation that is reflected by the collector forms a radiation beam B. The radiation beam B is focused at a point to form an image of the plasma formation region, which acts as a virtual radiation source for the illumination system IL. The point at which the radiation beam B is focused may be referred to as the intermediate focus. The radiation source SO is arranged such that the intermediate focus is located at or near to an opening in an enclosing structure of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system comprises a plurality of mirrors 13, 14 which are configured to project the radiation beam B onto a substrate W held by the substrate table WT, which may also be referred to as a substrate stage. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

The radiation sources SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

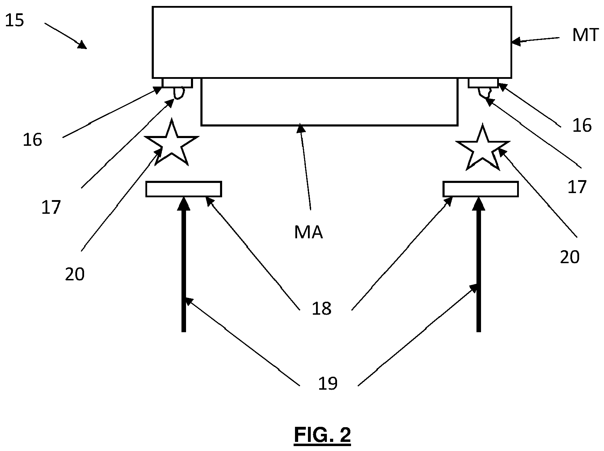

Figure 2 is a schematic depiction of an embodiment of the present invention. In this exemplary embodiment, the reticle stage comprises the support structure MT for the patterning device MA. As such, it will be appreciated that the reticle stage may be a system or sub-system of a lithography machine. The reticle stage is shown generally by numeral 15. The reticle stage 15 comprises one or more optical elements 16. The depicted example includes two optical elements 16, although there may be just one or more than two optical elements 16 in some embodiments. In the depicted example, the optical elements 16 are fiducials. The fiducials are used to calibrate the lithography apparatus and also provide information relating to positioning for the radiation beam. The optical elements 16 are contaminated with contamination 17, which may be carbon. The radiation beam targets 18 in the depicted example are illumination shutters for limiting an area of substrate to be illuminated. In other embodiments, the radiation beam targets may be provided adjacent the optical element 16, and may be a beam dump or a reticle clamp. In use, the radiation beam 19 is directed to the radiation beam target 18. The interaction of the radiation beam 19, the radiation beam target 18, and a surrounding gas, preferably hydrogen, generates a plasma 20. The plasma 20 is able to react with the contamination 17 and thereby clean the optical element 16. Since the optical element 16 is not the radiation beam target 18, the optical elements 16 are protected from being exposed to the radiation beam 19 directly and are therefore less likely to be damaged by overheating.

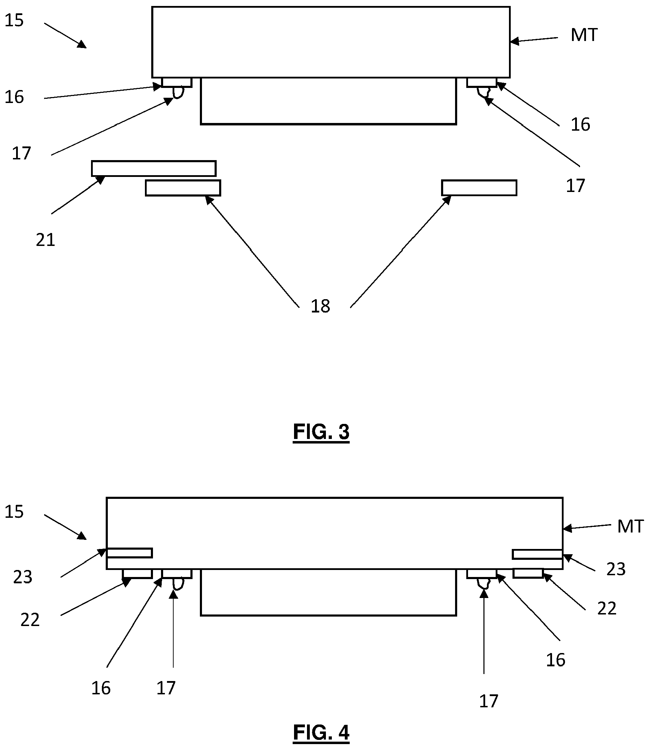

Figure 3 is similar to Figure 2, except that it also depicts a gas supply source 21. The gas supply source 21 supplies a gas, typically hydrogen, to the area around the reticle, this creates what is commonly referred to as the reticle mini-environment. As described, the present invention utilizes the generation of a plasma to clean a heat sensitive element of a reticle stage, such as a fiducial on a reticle stage. The gas supply source 21 is configured to generate a gas curtain which serves to reduce contamination of the surface of a reticle.

Figure 4 depicts an embodiment in which a beam dump 22 is located beside the optical element 16. As such, when a radiation beam illuminates the beam dump 22, a plasma is generated beside the optical element 16 and is able to clean away the contamination 17. The beam dump 22 may be separate from or contiguous with or connected to the optical element 16. There may be a conditioning system 23 configured to condition the beam dump 22 and/or the optical element 16. It will be appreciated that conditioning systems may be provided in embodiments in which the radiation beam target is an element other than a beam dump 22. The invention is not particularly limited by the exact nature of the conditioning system selected. In embodiments, the conditioning system 23 may include a water cooling circuit.

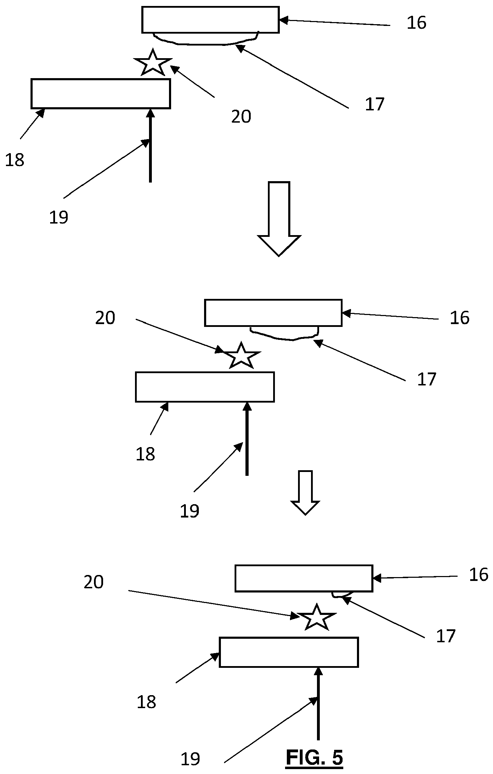

Figure 5 depicts an embodiment of the present invention in which the heat sensitive optical element and the radiation beam target are moved relative to one another in order to clean the contamination 17 from the heat sensitive optical element. In a first stage, the radiation beam target 18 and the radiation beam 19 are positioned to generate a plasma 20 in a first region of the contaminant 17 present on the heat sensitive element 16, which is an optical element. As the cleaning process progresses, the optical element 16 and the radiation beam target 18 move relative to one another such that the radiation beam target 18 and the radiation beam 19 are positioned to generate a plasma 20 in a second region of the contaminant 17 present on the optical element 16, thereby cleaning the second region. The cleaning process may progress further and the optical element 16 and the radiation beam target 18 move relative to one another such that the radiation beam target 18 and the radiation beam 19 are positioned to generate a plasma in a third region of the contaminant 17 present on the optical element 16, thereby cleaning the third region. It will be appreciated that this may continue until the optical element 16 has been sufficiently cleaned. The process may be repeated one or more times as necessary. There may be continuous or stepped relative movement between the optical element and the radiation beam target as necessary. In other embodiments, the optical element and the radiation beam target remain in static positions relative to one another and the radiation beam is moved over the radiation beam target in order to generate a plasma at different locations and thereby clean the optical element. It will be appreciated that the optical element and the radiation beam target may initially move relative to one another in order to put them into the required position for subsequent scanning of the radiation beam.

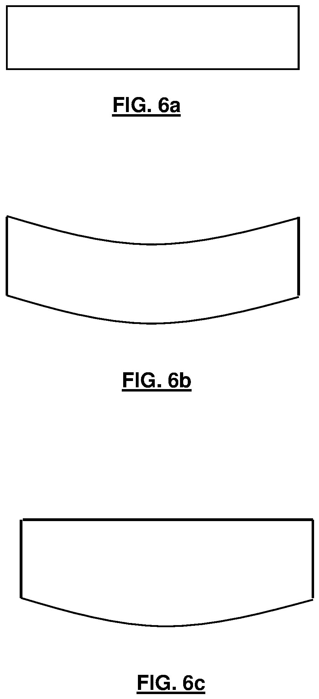

Figure 6a depicts a prior art fiducial, which is rectangular in shape and has four linear edges. In contrast, the fiducials according to the present invention, examples of which are shown in Figures 6b and 6c, comprise at least one curved edge. In particular, the fiducial of Figure 6b comprises two opposing curved edged, and the fiducial of Figure 6c comprises a single curved edge. Fiducials have reflective parts and absorber parts. As such, for a conventionally shaped fiducial as shown in Figure 6a, a large proportion of an incident radiation beam hits the absorber parts leading to very high temperatures on the fiducial, such as over 300°C, which leads to quick reflectivity degradation and the need to repair or replace the fiducial. By providing a fiducial with at least one curved edge, such as depicted in Figures 6b and 6c, the temperature of the fiducial may be significantly decreased, for example from over 300°C to less than 150°C. In addition, the maximum time a fiducial can be statically exposed to a radiation beam can be increased from less than 10 seconds to over a minute, such as up to 100 seconds.

Another way in which the temperature of the fiducial can be managed is by increasing the amount of reflective area of the fiducial as with a lower amount of absorber parts, less energy from an incident radiation beam is absorbed.

In summary, the present invention provides the cleaning of optical elements of a lithographic apparatus without directly exposing such elements to a radiation beam. This prevents damage of the elements and reduces the downtime of the lithographic apparatus. The radiation beam target may be configured to be able to withstand direct exposure to a radiation beam and so be unaffected by direct illumination by the radiation beam. A gas, typically hydrogen, may be converted to a plasma, which is then able to clean contamination, typically carbon, from the optical element. A further advantage of the present invention is that the issue of carbon being re-deposited on the heat sensitive elements due to breakdown of hydrocarbons is reduced or eliminated.

While specific embodiments of the invention have been described above, it will be appreciated that the invention may be practiced otherwise than as described.

The descriptions above are intended to be illustrative, not limiting. Thus it will be apparent to one skilled in the art that modifications may be made to the invention as described without departing from the scope of the claims set out below.

## Claims

1. A reticle stage for a lithography apparatus, said reticle stage comprising:
at least one optical element having an area to be cleaned;
a radiation beam target; and
a control system configured to direct a radiation beam to the radiation beam target wherein the interaction of the radiation beam and a gas creates an optical element-cleaning plasma, wherein
the radiation beam target is located to provide the optical element-cleaning plasma to the at least one optical element to clean the optical element, and wherein the at least one optical element is a different element than the radiation beam target.

2. The reticle stage for a lithography apparatus of claim 1 wherein the radiation beam target is an illumination shutter for limiting an area of a substrate to be illuminated, a reticle clamp, a beam dump, or an absorber element configured to absorb energy from the radiation beam and create a plasma.

3. The reticle stage for a lithography apparatus of claim 2 wherein the control system is configured to move the radiation beam target relative to the optical element having an area to be cleaned, and/or wherein the control system is configured to move the optical element having an area to be cleaned to a position where it is able to interact with the optical element-cleaning plasma.

4. The reticle stage for a lithography apparatus of any of the previous claims further comprising a gas supply source configured to supply the gas, optionally wherein the gas supply source is configured to maintain a gas pressure in the range of 1 to 20 Pa.

5. The reticle stage for a lithography apparatus of any of claims 1 to 4 wherein the radiation beam target is connected to the at least one optical element or is located within 25 mm of the at least one optical element.

6. The reticle stage for a lithography apparatus of any of the claims 2 to 5 wherein the radiation beam target further comprises a conditioning system.

7. The reticle stage for a lithography apparatus of any of the claims 2 to 6, wherein the radiation beam target is a beam dump, optionally wherein the beam dump comprises Cr.

8. The reticle stage for a lithography apparatus of any of the previous claims wherein the at least one optical element having an area to be cleaned comprises a fiducial mark having a mark area, optionally wherein the shape of the mark area comprises a rectangle wherein one of the sides comprises a further semispherical area, or semielliptical area, or comprises at least one curved edge.

9. The reticle stage for a lithography apparatus of any of the claims 2 to 8, wherein the at least one illumination shutter comprises two blades and the control system is configured to window the at least one optical element with the two blades.

10. The reticle stage for a lithography apparatus of the claim 9, wherein the blades are positioned parallel to one another and the at least one optical element is located between the blades.

11. The reticle stage for a lithography apparatus of any of the previous claims comprising a conditioning circuit and a spacer, wherein the spacer is connected to the at least one optical element and the conditioning circuit is configured to condition the at least one optical element and the spacer.

12. The reticle stage for a lithography apparatus of any of the previous claims wherein the gas is hydrogen.

13. The reticle stage for a lithography apparatus of any of the previous claims wherein the radiation beam is an EUV beam.

14. A method for cleaning at least one optical element of a reticle stage, said method comprising
- providing the reticle stage for a lithography apparatus of any of the previous claims,
- directing a radiation beam to the radiation beam target for creating an optical element-cleaning plasma.

15. A computer program product comprising instructions to cause the reticle stage for a lithography apparatus of any of the claims 1 to 13 to execute the steps of the method of claim 14.

16. A computer-readable medium having stored thereon the computer program of claim 15.

17. A fiducial for a lithographic apparatus, wherein said fiducial comprises at least one curved edge.

18. The fiducial according to claim 17, wherein the fiducial comprises two opposing linear edges, and/or wherein the fiducial comprises one curved edge opposite one substantially linear edge.

19. A lithography apparatus comprising the reticle stage for a lithography apparatus of any of the claims 1 to 13 or fiducial of any of the claims 17 or 18.

20. Use of a reticle stage for a lithography apparatus according to any of claims 1 to 13, a fiducial of claim claims 17 or 18, or the method according to claim 14 in a lithographic method or apparatus.
